# EUROPEAN PATENT APPLICATION

(11) **EP 4 575 636 A1**
(43) Date of publication of application: **25.06.2025**
(21) Application number: 23217927.5
(22) Date of filing: 19.12.2023
(51) Int. Cl.: G03F 7/00, G03F 9/00

(54) **A COLOR SELECTION MODULE FOR FILTERING A SELECTABLE WAVELENGTH BAND**

(71) Applicant: ASML Netherlands B.V., 5500 AH Veldhoven (NL)
(72) Inventor: VAN GREEVENBROEK, Hendrikus, Robertus, Marie, 5500 AH Veldhoven (NL)
(74) Representative: ASML Netherlands B.V.

(57) **Abstract**

This application provides a color selection module, and a method, for filtering a selectable wavelength band. The color selection module comprises a light input; a light output; a filter; an actuatable mirror, and a return mirror. The light input receives an input light beam. The actuatable mirror receives the input light beam and reflects the input light beam towards a selectable position on the filter. The actuatable mirror is configured for selecting the position by actuation. The filter receives the reflected input light beam from the actuatable mirror on the selectable position and filters the selectable wavelength band from the reflected input light beam. The return mirror reflects the filtered wavelength band towards the actuatable mirror, and the actuatable mirror reflects the filtered selectable wavelength band towards the light output. The light output outputs light of the selectable wavelength band.

## Description

### FIELD

The present invention relates to color selection modules for filtering a selectable wavelength band and a method for filtering a selectable wavelength band from an input light beam.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

In lithographic processes, it is desirable to make frequently measurements of the structures or patterns created, e.g., for process control and verification. Tools to make such measurement are typically called metrology tools or metrology devices. An illumination module for use in a metrology device requires the possibility to select one or more wavelength bands, where a wavelength band can comprise a central wavelength and a bandwidth. A known example achieves this with an illumination source which provides the input light, typically with a broadband spectrum; a first actuatable tilting mirror which directs the input light towards a first lens which collimates the light on a set of Linear Variable Filters (LVF). The LVF set comprises a short wavelength pass LVF and a long wavelength pass LVF, which depending on where the input light passes through the filters enables the selection of the wanted wavelength band. Subsequent to the filtering by passing through specific sections of the LVFs the filtered light passes through a second lens and continuous towards a second actuatable tilting mirror which directs the filtered light towards an output lens. The first and second actuatable tilting mirrors are synchronized to align the filtered light with the output lens. The known example thus uses actuators, tiltable mirrors and optics along the optical path both upstream towards the LVFs before filtering the light, and downstream positioned on the other side of the LVFs after filtering the light. Such actuators and optical elements are expensive, limit the design volume and are prone to wear due to moving parts.

### SUMMARY

According to a first aspect of the invention, there is provided a color selection module for filtering a selectable wavelength band. The color selection module comprises: a light input; a light output; a filter; an actuatable mirror, and a return mirror. The light input is for receiving an input light beam. The actuatable mirror receives the input light beam and reflects the input light beam towards a selectable position on the filter. The actuatable mirror is configured for selecting the position by actuation. The filter receives the reflected input light beam from the actuatable mirror on the selectable position and filters the selectable wavelength band from the reflected input light beam at the selectable position. The return mirror reflects the filtered light beam with the selectable wavelength band towards the actuatable mirror, and the actuatable mirror reflects the filtered light beam with the selectable wavelength band towards the light output. The light output outputs light of the selectable wavelength band. The described color selection module enables the selection of a requested wavelength band, with a defined central wavelength and bandwidth. By using a return mirror the same optical components as used upstream towards the filter before filtering the light, can be used downstream of the filter after filtering the light. Hereby costs and complexity of a color selection module are greatly reduced, in addition to creating more flexibility in allocating the design volume.

In an embodiment the filter of the color selection module for filtering a selectable wavelength band comprises a set of at least one long wavelength pass filter defining a lower limit of the bandwidth and at least one short wavelength pass filter defining an upper limit of the bandwidth. An effect of this embodiment is filtering the incoming light beam such that the outgoing light beam from the filter has the required bandwidth.

In an embodiment the filtering functionality of a filter is variable along a direction parallel to a physical border of the filter or along a direction at an angle with respect to a physical border of the filter. Depending on how the filtering functionality of a filter is variably arranged and how the filters are combined, different areas are enabled where you may select a different wavelength band.

In an embodiment the set of filters of the color selection module for filtering a selectable wavelength band can be non-movable with respect to each other, or moveable with respect to each other for changing the wavelength band filtering setting of the filter, optionally all filters are movable, optionally one of the filters is movable. As discussed above you can create different areas defining different ways to filter the required wavelengths bands. These areas may be tuned, enlarged, decreased, rotated, or in any other way manipulated.

In an embodiment the filter and return mirror of the color selection module for filtering a selectable wavelength band are positioned at an angle with respect to each other. This reduces the backscattering effect and/or reflection of unwanted wavelengths in the output of the filtered light.

In an embodiment the return mirror of the color selection module for filtering a selectable wavelength band is non-actuatable. This takes away the need of complex actuating motors or mechanisms for returning the filtered light beam.

In an embodiment the actuatable mirror is actuatable for selecting a position along one line of continuous selectable positions of the filter or actuatable for selecting a position from an area on the plane of the filter. This actuation allows steering and selecting any position on the filter arrangement.

In an embodiment the color selection module for filtering a selectable wavelength band comprises beam splitting and/or combining optical elements, and a further actuatable mirror to receive at least one of the splitted beams, and reflecting the at least one of the splitted beams towards the filter. By introducing beam splitting and/or combining optical elements the input light beam may be split into multiple beams, enabling multiple wavelength bands to be selected by steering them to different positions on the filter.

In an embodiment the beam splitting and/or combining optical elements of the color selection module for filtering a selectable wavelength band comprises a Polarizing Beam Splitter. The Polarizing Beam Splitter may perform the action of splitting the incoming light beam in different polarization states, and also recombine them.

In an embodiment the color selection module for filtering a selectable wavelength band can comprise at least one transmission filter for attenuating the reflected input light beam or the filtered light beam with the selectable wavelength band. This enables attenuation of the filtered light beam.

According to a second aspect of the invention, there is provided a method of filtering a selectable wavelength band from an input light beam.

According to a third aspect of the invention, there is provided a metrology apparatus. The metrology apparatus comprises a color selection module for filtering a selectable wavelength band.

According to a fourth aspect of the invention, there is provided a lithography apparatus. The lithography apparatus comprises a color selection module for filtering a selectable wavelength band.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a metrology apparatus;
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 depicts a schematic overview of a color selection module for filtering a selectable wavelength band, wherein figure6(a) depicts a top view and figure6(b) depicts a side view according to a viewing direction specified in figure6a).
- Figure 7 depicts a schematic overview of a color selection module for filtering a selectable wavelength band, similar to figure 6, with the difference that figure 7 depicts an embodiment wherein the filter and return mirror are at an angle with respect to each other. As in figure 6 also here figure7(a) depicts a top view and figure7(b) depicts a side view according to a viewing direction specified in figure7(a).
- Figure 8 depicts schematically examples of filter combinations, where figure 8(a) depicts a combination of filters wherein the filtering functionality of a filter varies along a direction parallel to a physical border of the, figure 8(b) depicts a combination of filters wherein the filtering functionality of a filter varies along a direction at an angle with respect to a physical border of the filter and figure 8(c) depicts a combination of filters split into identical wavelength dependence parts, additionally combined with at least one transmission filter.
- Figure 9 depicts a schematic overview of a color selection module similar to figure 6, with the difference that figure 9 depicts a top view of an embodiment for filtering multiple selectable wavelength bands.
- Figure 10 depicts a side view of the embodiment described in figure 9.
- Figure 11 depicts a schematic overview of a color selection module similar to figure 9, with a difference that figure 11 depicts an embodiment wherein the filter and return mirror are at an angle with respect to each other. An additional side view is not shown.
- Figure 12 depicts a schematic overview of a color selection module, similar to figure 6, with a difference that figure 12 depicts an embodiment using a concave mirror.
- Figure 13 depicts a schematic overview of a method of filtering a selectable wavelength band from an input light beam.

### DETAILED DESCRIPTION

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

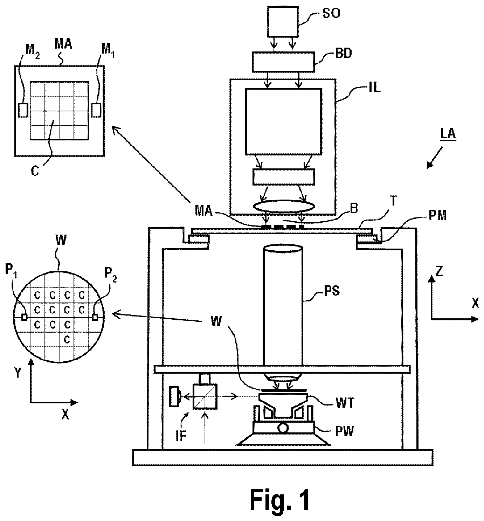

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

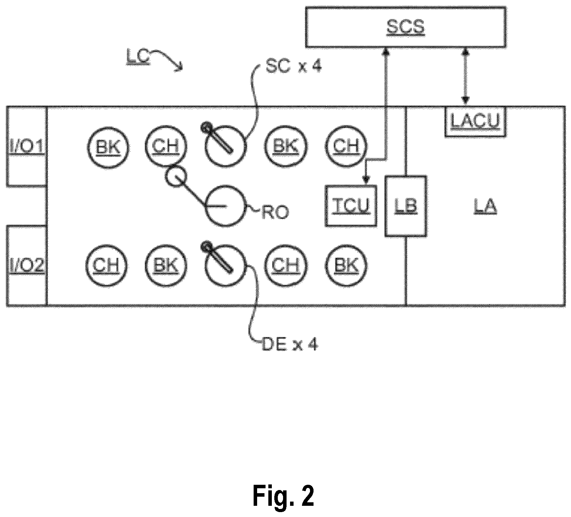

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

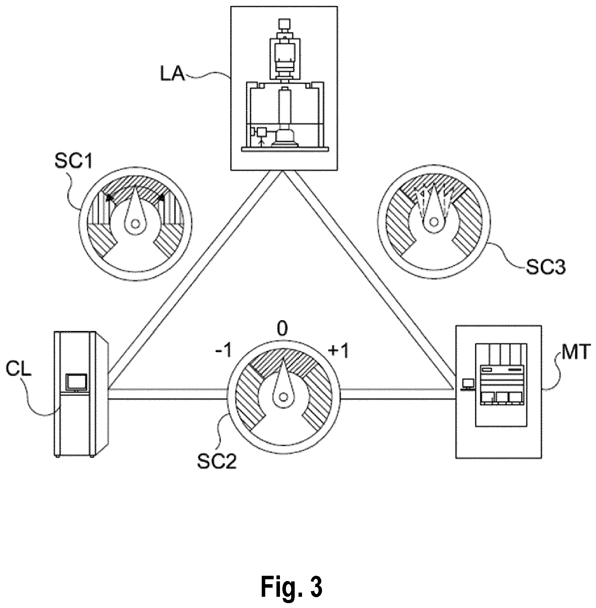

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

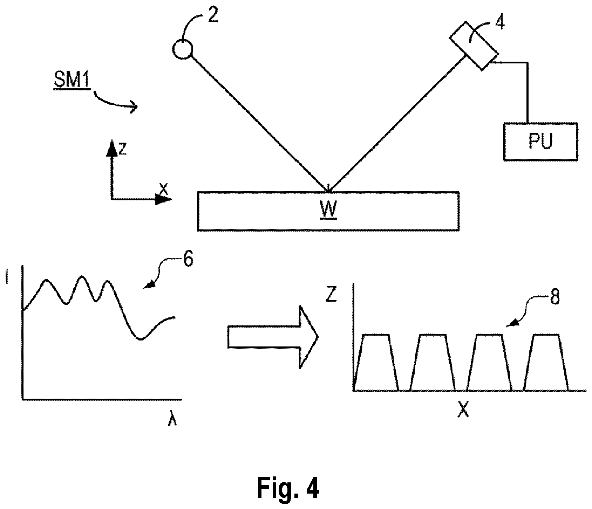

A metrology apparatus, such as a scatterometer, is depicted in figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

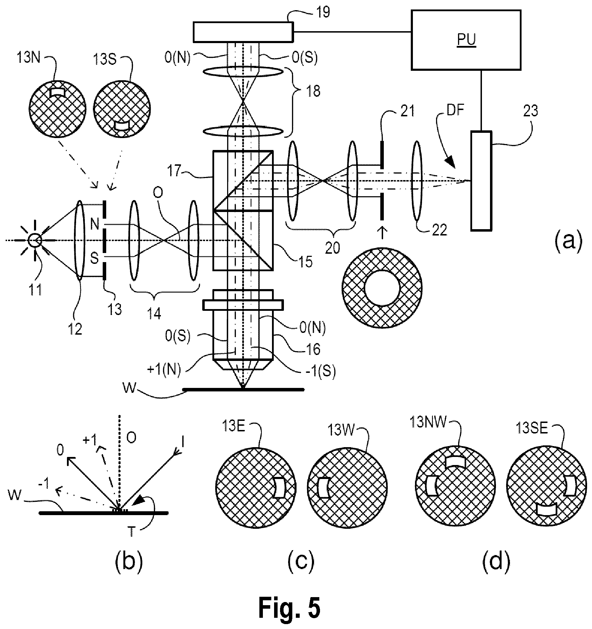

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

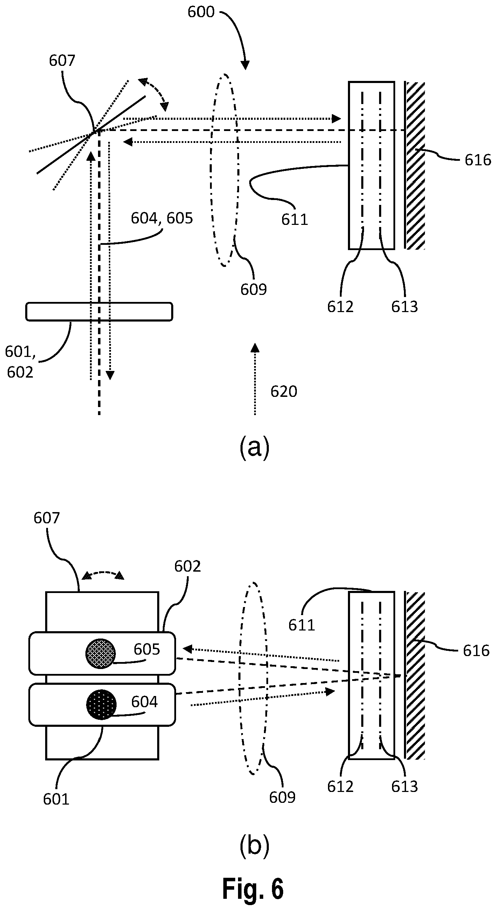

Figure 6 schematically depicts an overview of a color selection module 600 for filtering a selectable wavelength band. In the top view viewing direction of figure 6(a) a light input 601 receives an input light beam 604, where the input light beam 604 can be a broadband light, for example a white light, in a range of 400 nm to 1600 nm, or a range of 500 nm to 1050 nm. This input light can originate from for example a supercontinuum source, a Laser Pumped Plasma Source, a white light LED, an incandescent lamp, or any other suitable light source that generates broadband light. This input light beam 604 impinges on an actuatable mirror 607. The actuatable mirror 607 reflects the input light beam 604 towards the filter 611. By actuating the actuatable mirror 607 a selectable position on the filter 611 can be selected.

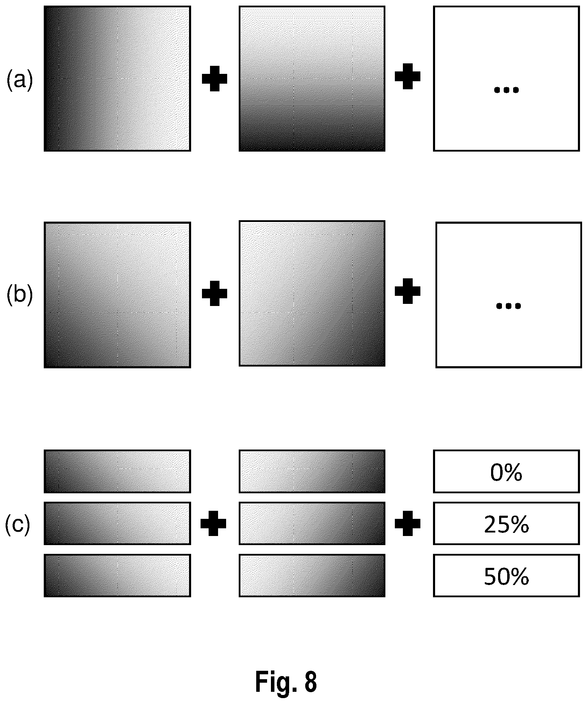

The filter 611 comprises at least one or a combination of multiple filters, each with different functionalities, as further described in detail in the description of figure 8. In figure 6 specifically, an example of a combination of two filters is depicted. A first filter can for example be a long wavelength pass filter 612, and a second filter can for example be a short wavelength pass filter 613. In a different embodiment the first filter can for example be a short wavelength pass filter 613, and a second filter can for example be a long wavelength pass filter 612. A detailed description on the long wavelength pass and short wavelength pass filters is provided in the description of figure 8. By first passing through the long wavelength pass filter 612 a certain range of shorter wavelengths will be filtered out. By then subsequently passing through the short wavelength pass filter 613 the unwanted longer wavelengths will be filtered out, resulting in a well-defined narrow wavelength band, with a chosen central wavelength and bandwidth. This filtering of the light can also be done by first passing through the short wavelength pass filter 613, followed by passing through the long wavelength pass filter 612. Having passed through the filter 611 the filtered light beam impinges on the return mirror 616 which returns the filtered light beam towards the actuatable mirror 607. From actuatable mirror 607 the filtered light beam, as output light 605, is directed towards a light output 602 for outputting the filtered light.

Please note that instead of `filtered light beam' or `filtered light' one can also read this as `filtered light beam with the selectable wavelength band'.

The actuatable mirror can for example be actuated to tilt around a centrally fixed point of the mirror. With selecting a selectable position we mean that the input light beam 604 is guided by the actuatable mirror 607 by actuation towards an area on the filter 611. By the actuation another area can be selected on the filter 611.

In an embodiment the actuatable mirror can select a position along one line of continuous selectable positions of the filter, which could also be understood as being actuatable in 1 dimension. The actuatable mirror could also selection a position from an area on the plane of the filter, which could also be understood as being actuatable in 2 dimensions. Furthermore in a practical embodiment the actuatable mirror comprises two mirrors controllably in one dimension to enable two dimensional control using two separate mirrors.

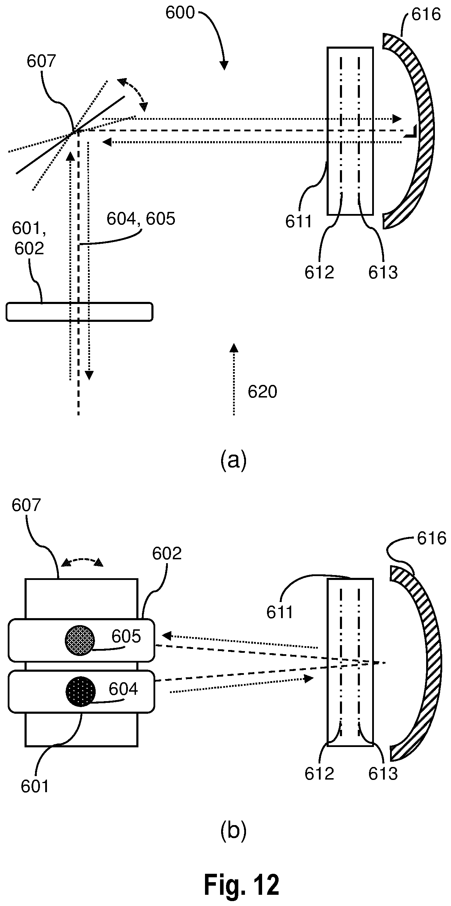

In an embodiment additionally there may be a lens element 609 positioned between the actuatable mirror 607 and the filter 611 as schematically depicted in figure 6. This lens element collimates the beam between the actuatable mirror 607 and filter 611 such that light impinges almost perpendicular on the mirror, at least when seen from the top view viewing direction of figure 6(a). This lens element 609 is required in an embodiment where the mirror 616 is substantially flat. Details on mirror 616 are further described in figure 12.

According to viewing direction 620 a side view is depicted in figure 6(b). As can be seen in this side view the input light beam 604 and output light beam 605 do not necessarily spatially overlap. An advantage of this is that the input and output are split, and no additional optical elements, like for example a beam splitter, or means, like for example polarized input, are needed to achieve this.

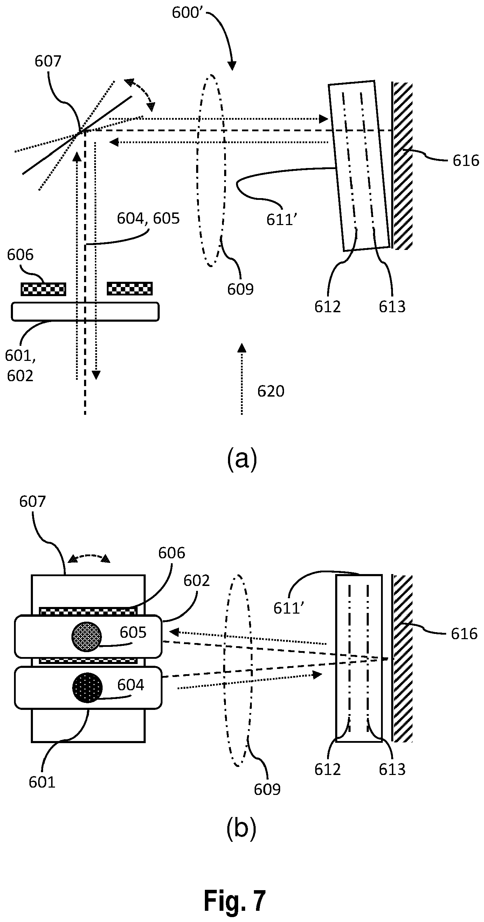

Figure 7 schematically depicts an overview of a color selection module 600' for filtering a selectable wavelength band. What can be seen in figure 7 is similar to what is depicted in and described on figure 6. A difference with respect to the color selection module 600 depicted in figure 6 is that the filter 611' is substantially at an angle with respect to the return mirror 616, as can be seen in the top view viewing direction of figure 7(a). In figure 6 the filter 611 and return mirror 616 are substantially parallel with respect to each other. Having the filter 611' and return mirror 616 substantially at an angle with respect to each other reduces the backscattering effect and/or reflections of unwanted wavelengths, in the example where the filter comprises filters that rely on reflecting unwanted wavelengths. According to viewing direction 620 a side view is depicted in figure 7(b), again showing as in figure 6(b) that the input light beam 604 and output light beam 605 do not necessarily spatially overlap.

In an embodiment additionally there may be an aperture element 606 positioned between the actuatable mirror 607 and the light output 602. The aperture element 606 can suppress and/or absorb any unwanted light that reaches the output 602, for example residual reflected radiation from the tilted filter 611'. In other words the aperture operates like a beam dump.

Figure 8 depicts schematically examples of filter combinations. In this description the filtering of a filter is meant as the functionality of the filter being variable depending on an area of the filter, as described further below. One example of filters used in these combinations are optical filters. These can for example transmit light in a particular range of wavelengths, while reflecting or absorbing or rejecting other wavelengths.

An example of such an optical filter is a long wavelength pass filter. Such a filter has what is typically referred to as a cut-on wavelength to define its working regime. This defines the transition between a region of reflection or absorption or rejection and a region of transmission. Wavelengths substantially shorter than this cut-on wavelength will be substantially absorbed or rejected, whereas wavelengths substantially longer will be substantially transmitted by the long wavelength pass filter. The filtering of a long wavelength pass filter can thus be described as having a variable cut-on wavelength depending or varying on the area of the filter. By actuation of the actuatable mirror 607 these areas are selectable positions for, for example defining a lower limit of the bandwidth of a required wavelength band.

For a long wavelength pass filter the cut-on wavelength can for example be defined within a range of 400-1600 nm, 600-1600 nm, 800-1600 nm, 450-900 nm, 600-900 nm or 800-900 nm.

Another example of such an optical filter is a short wavelength pass filter. Such a filter has what is typically referred to as a cut-off wavelength to define its working regime. This defines the transition between a region of transmission and a region of absorption or rejection. Wavelengths substantially longer than this cut-off wavelength will be substantially reflected or absorbed or rejected, whereas wavelengths substantially shorter will be substantially transmitted by the short wavelength pass filter. The filtering of a short wavelength pass filter can thus be described as having a variable cut-off wavelength depending or varying on the area of the filter. By actuation of the actuatable mirror 607 these areas are selectable positions for, for example defining an upper limit of the bandwidth of a required wavelength band.

For a short wavelength pass filter the cut-off wavelength can for example be defined within a range of 400-1600 nm, 400-1200 nm, 400-1000 nm, 450-900 nm, 400-800 nm, 400-600 nm or 400-500 nm.

In a practical implementation of the long wavelength pass and short wavelength pass filters as described above, it is to be understood that there is always a transition from 0% to 100% over a narrow wavelength range of the cut-on wavelength and cut-off wavelength.

Figure 8(a) depicts schematically a combination of filters wherein the filtering functionality of a filter varies along a direction parallel to a physical border of the filter. In the shown example of figure 8(a) two of such filters are drawn, where an additional filter can be an additional low pass filter or high pass filter, or another type of filter like a non-variable neutral density filter, a variable neutral density filter, or a polarization filter. The additional filter(s) can also be of the type as figure 8(b).

Figure 8(b) depicts schematically a combination of filters wherein the filtering functionality of a filter varies along a direction at an angle with respect to a physical border of the filter. In the shown example of figure 8(b) two of such filters are drawn, where an additional filter can be an additional low pass filter or high pass filter, or another type of filter like a non-variable neutral density filter, a variable neutral density filter, or a polarization filter. The additional filter(s) can also be of the type as figure 8(a).

Although it was explained above that the filtering functionality of a filter can vary along a direction parallel to a physical border of a filter or along a direction at an angle with respect to a physical border of a filter, the filtering functionality can also vary in another dimension, for example in any direction substantially not in the plane of the filter.

Figure 8(c) depicts schematically a combination of filters where one of more individual filters are split into identical wavelength dependence parts and optionally additionally combined with at least one transmission filter. The transmission filter(s) can be of different attenuation values, for example 0% attenuation, 25% attenuation, 50% attenuation,....

Other combinations which are not shown can include a combination of a filter wherein the filtering functionality of a filter varies along a direction parallel to a physical border of the filter with a filter wherein the filtering functionality of a filter varies along a direction at an angle with respect to a physical border of the filter, and other filters, like for example an additional low pass filter or high pass filter, or another type of filter like a non-variable neutral density filter, a variable neutral density filter, or a polarization filter.

The depicted filtering variability can be the same or different for each individual filter For example, the first shown filter can be a low wavelength pass filter as described above, the second filter can be high wavelength pass filter as described above. The described combinations comprise one, two, three, four, five, or more filters, wherein the filters can be specified as described above.

Although in the schematically drawn figures it might seem that the filter only has one substantially uninterrupted continuous pattern of filtering variability, this pattern can also comprise discrete steps where each step is a local area of the filter wherein the same filtering functionality is present within this local area. Each discrete step can have a varying filtering functionality compared to another discrete step, or have a substantially similar filtering functionality compared to another discrete step. The areas of the discrete steps can for example be shaped as rectangular, square, triangular, circular, oval, diamond, or any other shape derived or combined from these shapes. The distribution or pattern of the discrete steps can take any distribution and is not limited to a linear increase or decrease of varying filtering functionality.

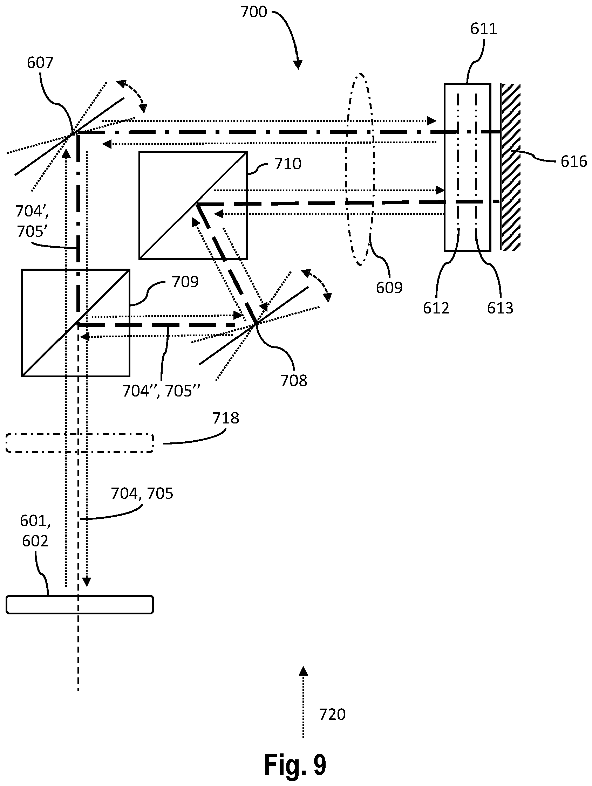

Figure 9 schematically depicts an overview of a color selection module 700 for filtering multiple selectable wavelength bands. In addition to the color selection module depicted in figure 6, several optical elements are added to enable filtering multiple selectable wavelength bands. A beam splitting and/or combining optical element 709 is introduced to receive and split input light beam 704 into splitted light beams 704' and 704". The beam splitting and/or combining optical element 709 can for example be a Polarizing Beam Splitter (PBS). When using a PBS the splitted light beams 704' and 704" have orthogonal polarization states.

The splitted input light beam 704' continues and impinges on actuatable mirror 607. Similar as in figure 6, the actuatable mirror 607 reflects the splitted input light beam 704' towards the filter 611. By actuating the actuatable mirror 607 a selectable position on the filter 611 can be selected. Having passed through the filter 611 the filtered light beam 705' impinges on the return mirror 616 which returns the filtered light beam towards the actuatable mirror 607. From actuatable mirror 607 the filtered light beam 705' is directed towards beam splitting and/or combining optical element 709.

In reflecting the splitted input light beam 704' by the actuatable mirror 607 towards the filter 611 the situation can occur where the reflected light beam needs to pass through the beam splitting and/or combining optical element 710. Subsequently after filtering through the filter 611 the filtered light beam 705' also needs to pass through the beam splitting and/or combining optical element 710 towards the actuatable mirror 607.

The splitted input light beam 704" is reflected towards and impinges on the actuatable mirror 708. The actuatable mirror 708 reflects the splitted input light beam 704" towards a second beam splitting and/or combining optical element 710. The beam splitting and/or combining optical element 710 can for example be a Polarizing Beam Splitter (PBS). The beam splitting and/or combining optical element 710 reflects the splitting input light beam 704" received from the actuatable mirror 708 towards the filter 611. By actuating the actuatable mirror 708 a selectable position on the filter 611 can be selected. Having passed through the filter 611 the filtered light beam 705" impinges on the return mirror 616 which returns the filtered light beam towards the beam splitting and/or combining optical element 710, which in turn reflects the filtered light beam 705" towards the actuatable mirror 708. From actuatable mirror 708 the filtered light beam 705" is directed towards beam splitting and/or combining optical element 709.

Filtered light beams 705' and 705" are recombined in the beam splitting and/or combining optical element 709 into a recombined output light beam. The recombined output light beam continues towards light output 602. Instead of using a single combined element for both beam splitting and combining, one can use separate elements for separately doing the splitting and separately doing the combining, as the input beam 704 and output beam 705 are spatially separated (as can be seen in a side view of a similar system, e.g. the system of Figure 6).

In an embodiment additionally there can be a depolarizer 718, depending on the output light requirements. In embodiments where it is necessary, required, or not of any significance that the recombined output light beam comprises substantially different colors with substantially different polarization states, then such a depolarizer 718 is optional. In embodiments where it is required that there is no specified polarization state per color, one may include a depolarizer 718. In such embodiments where a depolarizer 718 is included the recombined output light beam first passes through this depolarizer 718 after recombination in the beam splitting and/or combining optical element 709. The depolarized output light beam 705 continues towards light output 602. The depolarizer 718 can for example be a quarter wavelength plate, or other depolarizing device depending on the required polarization state.

As shown in the top view viewing direction of figure 9 the splitted input light beams 704' and 704" do not necessarily need to overlap spatially when impinging on the filter 611. This enables filtering of multiple selectable wavelengths bands.

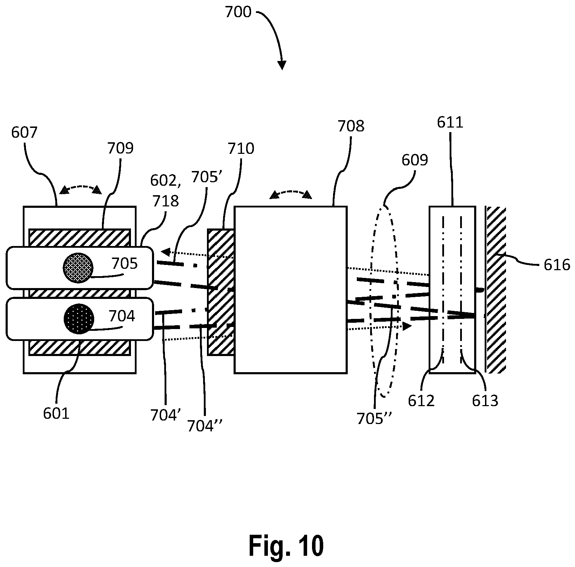

Figure 10 depicts a side view according to a viewing direction 720 as shown in figure 9. As can be seen in this side view the input light beam 704 and output light beam 705 do not necessarily spatially overlap. An advantage of this is, as described for figures 6 and 7, that the input and output are split, and no additional optical elements, like for example a beam splitter, or means, like for example polarized input, are needed to achieve this. This side view also shows that the splitted input light beams 704' and 704" do not necessarily need to overlap spatially when impinging on the filter 611. This enables filtering of multiple selectable wavelengths bands.

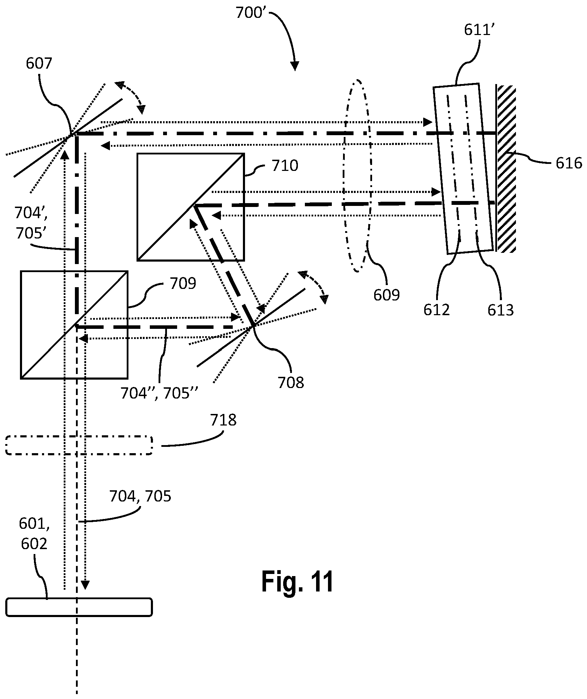

Figure 11 depicts a schematic overview of a color selection module 700' for filtering a selectable wavelength band similar to figure 9, with a difference that f11 depicts an embodiment wherein the filter 611' and return mirror 616 are at substantially at an angle with respect to each other, as can be seen in the top view viewing direction of f11. In figure 9 the filter 611 and return mirror 616 are substantially parallel with respect to each other. An additional side view is not shown as this is very similar to the side view according to viewing direction 720 of figure 10. Having the filter 611' and return mirror 616 at an angle with respect to each other reduces the backscattering effect and/or reflection of unwanted wavelengths in the output of the filtered light.

Figure 12 depicts a schematic overview of an embodiment similar to figure 6, with the difference that the mirror 616 is specifically a concave mirror. The curvature of the concave mirror needs to be determined such that locally where the filtered light beam impinges, it is reflected back towards the actuatable mirror in the same direction, meaning that locally the angle of incidence and the angle of reflection are 90 degrees with respect to the local surface of the mirror. In this embodiment where a concave mirror is used one may omit to use the lens element 609 of for example, among other figures, figure 6. Using a concave mirror as depicted in figure 12 can also be applied similarly to figure 7, the embodiment where the filter is substantially at an angle with respect to the mirror 616.

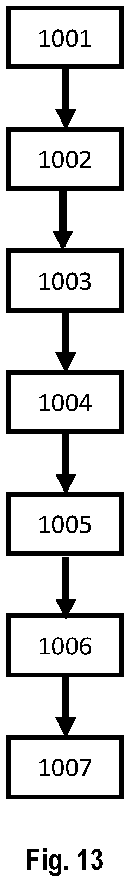

Figure 13 schematically depicts an overview of a method of filtering a selectable wavelength band from an input light beam. The method comprises receiving 1001 the input light beam through a light input, impinging 1002 the input light beam on an actuatable mirror, reflecting 1003 the input light beam towards a selectable position on a filter, the actuatable mirror selecting the position by actuation, receiving 1004 the reflected input light beam from the actuatable mirror on the selectable position, filtering 1005 the selectable wavelength band from the reflected input light beam at the selectable position, impinging 1006 the filtered light beam with the selectable wavelength band on a return mirror for reflecting the filtered light beam towards the actuatable mirror, receiving 1007 the reflected filtered light beam on the actuatable mirror for reflecting the reflected filtered light beam towards a light output.

In summary, this application provides a color selection module, and a method, for filtering a selectable wavelength band. The color selection module comprises a light input; a light output; a filter; an actuatable mirror, and a return mirror. The light input receives an input light beam. The actuatable mirror receives the input light beam and reflects the input light beam towards a selectable position on the filter. The actuatable mirror is configured for selecting the position by actuation. The filter receives the reflected input light beam from the actuatable mirror on the selectable position and filters the selectable wavelength band from the reflected input light beam. The return mirror reflects the filtered wavelength band towards the actuatable mirror, and the actuatable mirror reflects the filtered selectable wavelength band towards the light output. The light output outputs light of the selectable wavelength band.

Further embodiments are disclosed in the subsequent list of numbered clauses:
1. A color selection module for filtering a selectable wavelength band comprising
   - a light input for receiving an input light beam;
   - a filter;
   - an actuatable mirror, wherein
      i) the actuatable mirror is for receiving the input light beam and reflecting the input light beam towards a selectable position on the filter, the actuatable mirror being configured for selecting the position by actuation, and
      ii) the filter is for receiving the reflected input light beam from the actuatable mirror on the selectable position and for filtering the selectable wavelength band from the reflected input light beam at the selectable position;
   - a light output for outputting light of the selectable wavelength band; and
   - a return mirror for reflecting the filtered light beam with the selectable wavelength band towards the actuatable mirror, and the actuatable mirror being configured for reflecting the filtered light beam with the selectable wavelength band towards the light output.
2. A color selection module as defined in clause 1, further comprising a lens element positioned between the actuatable mirror and the filter for collimating the reflected input light beam between the actuatable mirror and the filter.
3. A color selection module as defined in clauses 1 or 2, further comprising an aperture element positioned between the actuatable mirror and the light output.
4. A color selection module as defined in any of the previous clauses, wherein the wavelength band has a bandwidth, the filter comprises at least two filters, wherein at least one of the at least two filters comprises a long wavelength pass filter defining a lower limit of the bandwidth and at least one of the at least two filters comprises a short wavelength pass filter defining an upper limit of the bandwidth.
5. A color selection module as defined in any of the previous clauses, wherein the filtering functionality of a filter varies.
6. A color selection module as defined in any of the previous clauses, wherein the variation of the filtering functionality is along a direction parallel to a physical border of the filter or along a direction at an angle with respect to a physical border of the filter.
7. A color selection module as defined in any of the previous clauses, wherein the filtering functionality of a filter varies along a direction parallel to a physical border of the filter or along a direction at an angle with respect to a physical border of the filter.
8. A color selection module as defined in any of the previous clauses, wherein the filters in the set of filters are non-movable with respect to each other.
9. A color selection module as defined in any of the previous clauses, wherein the filters in the set of filters are movable with respect to each other for changing the wavelength band filtering setting of the filter, optionally all filters are movable, optionally one of the filters is movable.
10. A color selection module as defined in any of the previous clauses, wherein the filter and the return mirror for reflecting the filtered wavelength band towards the actuatable mirror are positioned at an angle with respect to each other.
11. A color selection module as defined in any of the previous clauses, wherein the return mirror for reflecting the filtered wavelength band towards the actuatable mirror is non-actuatable
12. A color selection module as defined in any of the previous clauses, wherein the actuatable mirror is actuatable for selecting a position along one line of continuous selectable positions of the filter.
13. A color selection module as defined in any of the previous clauses, wherein the actuatable mirror is actuatable for selecting a position from an area on the plane of the filter.
14. A color selection module as defined in any of the previous clauses, wherein the actuatable mirror is actuatable for selecting a position in at least one of the following ways:
   - along one line of continuous selectable positions of the filter;
   - from an area on the plane of the filter.
15. A color selection module as defined in any of the previous clauses, comprising beam splitting optical elements, beam combining optical elements, and a further actuatable mirror for receiving at least one of the splitted beams, and reflecting the at least one of the splitted beams towards the filter.
16. A color selection module as defined in clause 15, wherein the beam splitting optical elements comprise a Polarizing Beam Splitter.
17. A color selection module as defined in any of the previous clauses, wherein the filter comprises at least one transmission filter for attenuating the reflected input light beam or the filtered light beam with the selectable wavelength band.
18. A method of filtering a selectable wavelength band from an input light beam, the method comprising:
   - Receiving the input light beam through a light input;
   - Impinging the input light beam on an actuatable mirror;
   - Reflecting the input light beam towards a selectable position on a filter, the actuatable mirror selecting the position by actuation;
   - Receiving the reflected input light beam from the actuatable mirror on the selectable position;
   - Filtering the selectable wavelength band from the reflected input light beam at the selectable position;
   - Impinging the filtered light beam with the selectable wavelength band on a return mirror for reflecting the filtered light beam towards the actuatable mirror;
   - Receiving the reflected filtered light beam on the actuatable mirror for reflecting the reflected filtered light beam towards a light output.
19. A metrology apparatus comprising a color selection module for filtering a selectable wavelength band as defined in any of the clauses 1 to 17, operable to use said filtered selectable wavelength as an illumination source for measuring structures or patterns on a substrate.
20. A lithography apparatus comprising a color selection module for filtering a selectable wavelength band as defined in any of the clauses 1 to 17 or comprising the metrology apparatus of clause 19.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

## Claims

1. A color selection module for filtering a selectable wavelength band comprising
- a light input for receiving an input light beam;
- a filter;
- an actuatable mirror, wherein
i) the actuatable mirror is for receiving the input light beam and reflecting the input light beam towards a selectable position on the filter, the actuatable mirror being configured for selecting the position by actuation, and
ii) the filter is for receiving the reflected input light beam from the actuatable mirror on the selectable position and for filtering the selectable wavelength band from the reflected input light beam at the selectable position;
- a light output for outputting light of the selectable wavelength band; and
- a return mirror for reflecting the filtered light beam with the selectable wavelength band towards the actuatable mirror, and the actuatable mirror being configured for reflecting the filtered light beam with the selectable wavelength band towards the light output.

2. A color selection module as claimed in claim 1, further comprising a lens element positioned between the actuatable mirror and the filter for collimating the reflected input light beam between the actuatable mirror and the filter.

3. A color selection module as claimed in claim 1 or 2, further comprising an aperture element positioned between the actuatable mirror and the light output.

4. A color selection module as claimed in any of the previous claims, wherein the wavelength band has a bandwidth, the filter comprises at least two filters, wherein at least one of the at least two filters comprises a long wavelength pass filter defining a lower limit of the bandwidth and at least one of the at least two filters comprises a short wavelength pass filter defining an upper limit of the bandwidth.

5. A color selection module as claimed in any of the previous claims, wherein the filtering functionality of a filter varies.

6. A color selection module as claimed in any of the previous claims, wherein the variation of the filtering functionality is along a direction parallel to a physical border of the filter or along a direction at an angle with respect to a physical border of the filter.

7. A color selection module as claimed in any of the previous claims, wherein the filters in the set of filters are non-movable with respect to each other.

8. A color selection module as claimed in any of the previous claims, wherein the filters in the set of filters are movable with respect to each other for changing the wavelength band filtering setting of the filter, optionally all filters are movable, optionally one of the filters is movable.

9. A color selection module as claimed in any of the previous claims, wherein the filter and the return mirror for reflecting the filtered wavelength band towards the actuatable mirror are positioned at an angle with respect to each other.

10. A color selection module as claimed in any of the previous claims, wherein the return mirror for reflecting the filtered wavelength band towards the actuatable mirror is non-actuatable

11. A color selection module as claimed in any of the previous claims, wherein the actuatable mirror is actuatable for selecting a position in at least one of the following ways:
- along one line of continuous selectable positions of the filter;
- from an area on the plane of the filter.

12. A color selection module as claimed in any of the previous claims, comprising beam splitting optical elements, beam combining optical elements, and a further actuatable mirror for receiving at least one of the splitted beams, and reflecting the at least one of the splitted beams towards the filter.

13. A color selection module as claimed in any of the previous claims, wherein the filter comprises at least one transmission filter for attenuating the reflected input light beam or the filtered light beam with the selectable wavelength band.

14. A method of filtering a selectable wavelength band from an input light beam, the method comprising:
- receiving the input light beam through a light input;
- impinging the input light beam on an actuatable mirror;
- reflecting the input light beam towards a selectable position on a filter, the actuatable mirror selecting the position by actuation;
- receiving the reflected input light beam from the actuatable mirror on the selectable position;
- filtering the selectable wavelength band from the reflected input light beam at the selectable position;
- impinging the filtered light beam with the selectable wavelength band on a return mirror for reflecting the filtered light beam towards the actuatable mirror;
- receiving the reflected filtered light beam on the actuatable mirror for reflecting the reflected filtered light beam towards a light output.

15. A metrology apparatus comprising a color selection module for filtering a selectable wavelength band as defined in any of the claims 1 to 13, operable to use said filtered selectable wavelength as an illumination source for measuring structures or patterns on a substrate.
